# EUROPEAN PATENT APPLICATION

(11) **EP 1 950 804 A2**
(43) Date of publication of application: **30.07.2008**
(21) Application number: 08001082.0
(22) Date of filing: 22.01.2008
(51) Int. Cl.: H01L 21/77, H01L 27/12

(54) **Display device and manufacturing method of the same**

(30) Priority: 26.01.2007 KR 20070008237; 09.02.2007 KR 20070013882
(71) Applicant: Samsung Electronics Co., Ltd., Yeongtong-gu Suwon-city, Gyeonggi-do 442-742 (KR)
(72) Inventor: Kim, Byoung-june, Seongdong-gu Seoul (KR); Choi, Yong-mo, Osan-si Gyeonggi-do (KR); Choi, Beohm-rock, Gangnam-gu Seoul (KR); Yang, Sung-hoon, Seongdong-gu Seoul (KR); Oh, Hwa-yeul, Yeongdeungpo-gu Seoul (KR); Choi, Jae-ho, Jongno-gu Seoul (KR); Huh, Jong-moo, Hwaseong-si Gyeonggi-do (KR)
(74) Representative: Weitzel, Wolfgang

(57) **Abstract**

A display device includes an insulating substrate, a switching TFT formed on the substrate that receives a data voltage and that includes a first semiconductor layer, a driving TFT formed on the substrate that includes a control terminal connected to an output terminal of the switching TFT and a second semiconductor layer including polysilicon and a halogen material, an insulating layer formed on the switching TFT and the driving TFT, a first electrode formed on the insulating layer and electrically connected to an output terminal of the driving TFT, an organic light emitting layer formed on the first electrode, and a second electrode formed on the organic light emitting layer.

## Description

### BACKGROUND

This disclosure relates to display devices, such as organic light emitting diode (OLED) devices and liquid crystal displays (LCDs), and methods for manufacturing them.

Flat panel displays, such as OLED displays and LCDs, have recently become preferred alternatives to conventional cathode ray tube (CRT) displays.

LCDs typically include a display panel comprising a first substrate having a plurality of thin film transistors (TFTs) formed thereon, a second substrate disposed opposite to the first substrate, and a layer of a liquid crystal material sandwiched between the first and second substrates. LCDs may further include a backlight unit disposed in back of the first substrate. The molecular arrangement of the liquid crystal layer is varied to control the transmissivity of light emitted from the backlight unit and passing through the display panel. The molecular arrangement of the liquid crystal layer is controllably varied in accordance with voltages respectively applied to pixel electrodes connected to respective ones of the TFTs.

OLED displays include an organic light emitting layer that receives electrons and holes so as to emit light. OLED displays have recently begun to attract increased attention owing to certain of their advantages, e.g., low driving voltages, light-weight and thinness, wide viewing angles, fast response times, and the like.

OLED displays also include a TFT panel, and the intensity of light emitted by the organic light emitting layer therein is a function of the amount of holes transported from the pixel electrodes connected to the TFTs thereof. Recently, polysilicon having good mobility has been used as the semiconductor layer of the TFTs. However, TFTS using polysilicon are not uniform in quality, so that the performance of displays containing such TFTs can become unstable.

### BRIEF SUMMARY

In accordance with the exemplary embodiments disclosed herein, display devices having stable display performance are provided, together with methods for manufacturing them.

In one embodiment, a display device, comprises: an insulating substrate; a switching TFT formed on the insulating substrate, the switching TFT receiving a data voltage and comprising a first semiconductor layer; a driving TFT formed on the insulating substrate, the driving TFT having a control terminal connected to an output terminal of the switching TFT and comprising a second semiconductor layer including polysilicon and a halogen material; an insulating layer formed on the switching TFT and the driving TFT; a first electrode formed on the insulating layer and electrically connected to an output terminal of the driving TFT; an organic light emitting layer formed on the first electrode; and, a second electrode formed on the organic light emitting layer.

The first semiconductor layer may include amorphous silicon.

The halogen material may include fluorine.

The second semiconductor layer in a channel region of at least one of the TFTs may have a thickness that is less than the thickness of the second semiconductor layer in a region surrounding the channel region.

The second semiconductor layer may have a halogen content ranging from 1 at.% to 3 at.%.

The halogen material may be uniformly distributed in the second semiconductor layer.

The driving TFT may further comprise a gate electrode, the gate electrode being disposed between the second semiconductor layer and the second electrode and corresponding in size and shape to the channel region.

The display may further comprise a buffer layer that includes silicon oxide interposed between the insulating substrate and the second semiconductor layer.

The second semiconductor layer may comprise a first layer including the halogen material at a first content, and a second layer formed on the first layer and including the halogen material at a second content that is less than the first content.

The first layer may have a uniform thickness.

The halogen content of the second layer may be substantially zero.

In one embodiment, a method of manufacturing a display device comprises: forming an amorphous silicon layer on an insulating substrate while supplying a first silicon source gas and a halogen source gas thereto; forming an amorphous ohmic contact layer on the amorphous silicon layer while supplying a second silicon source gas and an impurity source gas thereto; forming a semiconductor layer and an ohmic contact layer by crystallizing and patterning the amorphous silicon layer and the amorphous ohmic contact layer; forming a source electrode and a drain electrode on the ohmic contact layer, the source and drain electrodes being spaced apart from each other and having a channel region disposed therebetween; exposing the semiconductor layer by removing the portion of the ohmic contact layer that is not covered by the source electrode and the drain electrode; forming an insulating layer on the source electrode, the drain electrode and the exposed semiconductor layer; and, forming a gate electrode corresponding in size and shape to the exposed semiconductor layer on the insulating layer.

A flux ratio of the halogen source gas to the first silicon source gas may range from 1/3 to 2/3.

The halogen source gas may include silicon halide.

The halogen source gas may include SiF₄, and the silicon source gas may include SiH₄.

The crystallizing may be performed by a solid phase crystallization method.

The method may further comprise forming a pixel electrode connected to the drain electrode.

The method may further comprise forming an organic light emitting layer on the pixel electrode.

In one embodiment, a method of manufacturing a display device comprises: forming a switching TFT and a driving TFT on an insulating substrate, the driving TFT comprising a control terminal electrically connected to an output terminal of the switching TFT; forming a first electrode that is electrically connected to the driving TFT; forming an organic light emitting layer on the first electrode; and, forming a second electrode on the organic light emitting layer, wherein the forming of the driving TFT comprises: forming an amorphous silicon layer on the insulating substrate while supplying a first silicon source gas and a halogen source gas thereto; forming an amorphous ohmic contact layer on the amorphous silicon layer while supplying a second silicon source gas and an impurity source gas thereto; forming a semiconductor layer and an ohmic contact layer by crystallizing and patterning the amorphous silicon layer and the amorphous ohmic contact layer; forming a source electrode and a drain electrode on the ohmic contact layer, the source and drain electrodes being spaced apart from each other and having a channel region disposed therebetween; exposing the semiconductor layer by removing the portion of the ohmic contact layer that is not covered by the source electrode and the drain electrode; forming an insulating layer on the source electrode, the drain electrode and the exposed semiconductor layer; and, forming a gate electrode corresponding to the exposed semiconductor layer on the insulating layer.

A flux ratio of the halogen source gas to the first silicon source gas may range from 1/3 to 2/3.

In one embodiment, a method for manufacturing a display device comprises: forming a first amorphous silicon layer on an insulating substrate while supplying a first silicon source gas and a halogen source gas thereto; forming a second amorphous silicon layer on the first amorphous silicon layer while supplying a second silicon source gas thereto; forming an amorphous ohmic contact layer on the second amorphous silicon layer while supplying a third silicon source gas and an impurity source gas thereto; forming a semiconductor layer and an ohmic contact layer by crystallizing and patterning the first amorphous silicon layer, the second amorphous silicon layer and the amorphous ohmic contact layer; forming a source electrode and a drain electrode on the ohmic contact layer, the source and drain electrodes being spaced apart from each other and having a channel region disposed therebetween; and, removing the portion of the ohmic contact layer that is not covered by the source electrode and the drain electrode.

### BRIEF DESCRIPTION OF THE DRAWINGS

FIG. 1 is a partial equivalent circuit diagram of a first exemplary embodiment of a display device in accordance with the present invention, showing a single exemplary pixel thereof;
FIG. 2 is a partial plan view of the exemplary display device of FIG. 1, showing the single exemplary pixel area thereof;
FIG. 3 is a partial cross-sectional view of the exemplary-display device of FIG. 2, as seen along the lines of the section III-III taken therein;
FIGS. 4A and 4B are graphs illustrating the dependency of the properties of a TFT on the fluorine content thereof;
FIGS. 5A through 5D are graphs illustrating the dependency of the properties of a TFT on the ratio of the respective fluxes of fluorine and silicon source gases used during the manufacture thereof;
FIGS. 6A through 6L are partial cross-sectional views of the first exemplary display device, showing sequential processes involved in an exemplary embodiment of a method for manufacturing the device in accordance with the present invention;
FIG. 7 is a partial cross-sectional view of a second exemplary embodiment of a display device in accordance with the present invention;
FIG. 8 is a partial cross-sectional view of a third exemplary embodiment of a display device in accordance with the present invention;
FIG. 9 is an enlarged view of the portion "A" of the exemplary display of FIG. 8 outlined by phantom lines;
FIGS. 10A through 10F are graphs illustrating the dependency of the properties of a TFT on the configuration of the semiconductor layer contained therein;
FIG. 11 is an enlarged partial cross-sectional view of a fourth exemplary embodiment of a display device in accordance with the present invention; and,
FIG. 12 is a partial cross-sectional view of a fifth exemplary embodiment of a display device in accordance with the present invention.

### DETAILED DESCRIPTION

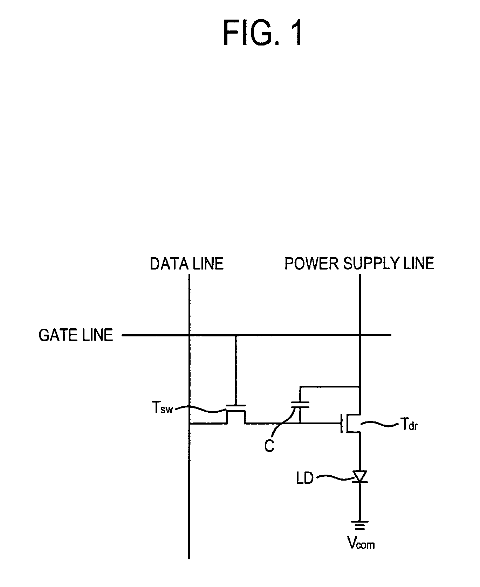

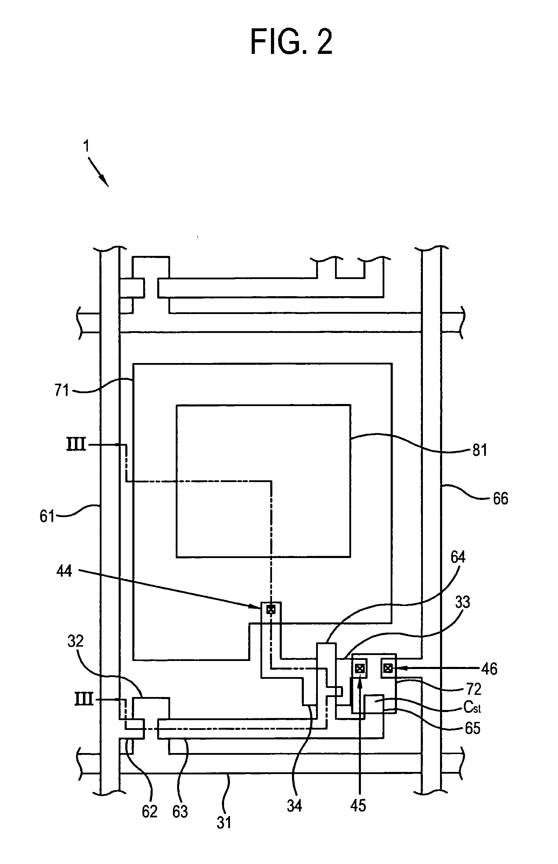

FIG. 1 is a partial equivalent circuit diagram of a first exemplary embodiment of a display device in accordance with the present invention, showing a single exemplary pixel area thereof, and FIG. 2 is a partial plan view of the exemplary pixel area of the display device of FIG. 1.

A plurality of signal lines are provided for transferring signals to each of the pixels. The signal lines include a gate line for transferring a scanning signal thereto, a data line for transferring a data signal thereto, and a power supply line for transferring a driving voltage thereto. The data line and the power supply line are arranged to be parallel and adjacent to each other, and the gate line extends perpendicular to the data and power supply lines.

As illustrated in FIG. 1, each pixel includes an organic light emitting diode LD, a switching thin film transistor (TFT) Tsw, a driving TFT Tdr, and a capacitor C.

The driving TFT Tdr of the pixel has a control terminal, an input terminal, and an output terminal, and the control terminal is connected to the switching TFT Tsw. Also, the input terminal is connected to the power supply line, and the output terminal is connected to the organic light emitting diode LD.

The organic light emitting diode LD of the pixel has an anode connected to the output terminal of the driving TFT Tdr and a cathode through which a common voltage is input. The organic light emitting diode LD varies the strength of the light that it emits in accordance with the output voltage of the driving TFT Tdr so as to display one pixel element of an image displayed by the display device. The intensity of the current of the driving TFT Tdr varies according to the voltage between the control and the output terminals thereof.

The switching TFT Tsw also has a control terminal, an input terminal, and an output terminal, and the control terminal is connected to the gate line. In addition, the input terminal is connected to the data line, and the output terminal is connected to the control terminal of the driving TFT Tdr. The switching TFT Tsw transfers a data signal input via the data line in response to a scanning signal input via the gate line to the driving TFT Tdr.

The capacitor C is connected between the control terminal and the input terminal of the driving TFT Tdr. The capacitor C is charged with a data signal voltage input to the control terminal of the driving TFT Tdr and functions to maintain that voltage after the driving TFT Tdr is turned off.

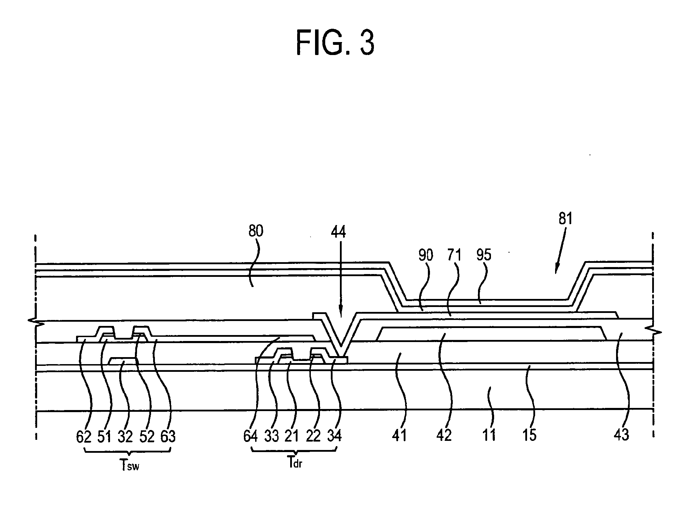

With reference to FIGS. 2 and 3, following is a detailed description of the first exemplary display device.

A buffer layer 15 is formed on an insulating substrate 11. The buffer layer 15 may include silicon oxide, and prevents any impurities of the insulating substrate 11 from being introduced into a amorphous silicon layer formed later while the amorphous silicon layer is being crystallized.

A driving semiconductor layer 21 and a driving ohmic contact layer 22 are then formed on the buffer layer 15. The driving semiconductor layer 21 includes polysilicon containing a halogen material, such as fluorine. In the driving semiconductor layer 21, the fluorine content ranges from 1 atomic percent (at.%) through 3 at.%, and further, is relatively uniformly distributed within the driving semiconductor layer 21.

Alternatively, the driving semiconductor layer 21 may contain another halogen material, such as bromine or chlorine. The halogen material contained in the driving semiconductor layer 21 gives uniform properties to the driving TFT Tdr, as described in more detail below.

The driving ohmic contact layer 22 includes n+ polysilicon doped with n-type impurities, such as boron B.

A first metal layer is formed on the buffer layer 15, the driving semiconductor layer 21 and the driving ohmic contact layer 22. The first metal layer includes a gate line 31, a switching gate electrode 32, a driving source electrode 33 and a driving drain electrode 34. The gate line 31 and the switching gate electrode 32 are formed as a single body.

The driving source electrode 33 and the driving drain electrode 34 are spaced apart from each other, with a channel region disposed therebetween. In the channel region, the driving ohmic contact layer 22 is removed to expose the driving semiconductor layer 21. As a result, the driving semiconductor layer 21 is relatively thinner in the channel region than in the region surrounding the channel.

A first insulating layer 41 is formed on the first metal layer. The first insulating layer 41 may include silicon nitride.

A switching semiconductor layer 51 and a switching ohmic contact layer 52 are formed on the first insulating layer 41. The switching semiconductor layer 51 and the switching ohmic contact layer 52 are formed so as to correspond in size and shape to the switching gate electrode 32, and may comprise amorphous silicon.

A second metal layer is formed on the first insulating layer 41, the switching semiconductor layer 51 and the switching ohmic contact layer 52. In addition, a color filter 42 is formed on the first insulating layer 41 below a pixel electrode 71, described below.

The second metal layer includes a data line 61, a switching source electrode 62, a switching drain electrode 63, a driving gate electrode 64, a storage capacity line 65, and a power supply line 66.

The data line 61 and the switching source electrode 62 are formed as a single body. The switching drain electrode 63, the driving gate electrode 64, and the storage capacity line 65 are also formed as a single body.

The switching source electrode 62 and the switching drain electrode 63 are spaced apart from each other, with the channel region situated therebetween. In the channel region, the switching ohmic contact layer 52 is removed to expose the switching semiconductor layer 51. As a result, the switching semiconductor layer 51 is relatively thin in the channel region.

A second insulating layer 43 is formed on the second metal layer. The second insulating layer 43 is referred to as an "overcoat" layer, and may comprise organic materials, including one of the benzocyclobutene (BCB) series, olefine series, acrylic resin series, polyimide series, and a fluorine resin, among others.

Contact holes 44, 45, and 46 are formed on the second insulating layer 43. The contact hole 44 exposes the driving drain electrode 34; the contact hole 45 exposes the driving source electrode 33; and, the contact hole 46 exposes the power supply line 66. In the contact holes 44 and 45, the first insulating layer 41 is also removed.

A transparent conducting layer is formed on the second insulating layer 43. The transparent conducting layer includes a pixel electrode 71 and a bridge electrode 72, and may be made of indium tin oxide (ITO) or indium zinc oxide (IZO).

The pixel electrode 71 is electrically connected to the driving drain electrode 34 via the contact hole 44. The bridge electrode 72 electrically connects the switching source electrode 33 with the power supply line 66 via the contact holes 45 and 46. The storage capacity line 65 is extended below the bridge electrode 72 so as to form a storage capacitor Cst in combination therewith.

A wall 80 is formed on the second insulating layer 43. The wall 80 separates the pixel electrodes 71 from each other, and is partially removed to form an aperture region 81 through which the pixel electrode 71 is exposed.

An organic light emitting layer 90 is formed on both the wall 80 and the pixel electrode 71 exposed through the aperture region 81.

Further, an electron injection layer, an electron transport layer, a hole injection layer, a hole transport layer, and other layers that are not shown in the figure, may be formed between the pixel electrode 71 and a common electrode 95.

The hole injection and hole transport layers include strong fluorescent amine derivatives. For example, triphenyldiamine derivatives, styryl amine derivatives, and amine derivatives having an aromatic condensed ring, or the like, may be used for the hole injection and hole transport layers.

The electron transport layer includes quinoline derivatives, for example, aluminum tris(8-hydroxyquinoline) (Alq3). Also, phenyl anthracene derivatives, tetraarylethen derivatives may be used for the electron transport layer. The electron injection layer may include barium(Ba) or calcium (Ca).

A region in which the pixel electrode 71 and the organic light emitting layer 90 are in direct contact with each other is referred to herein as a pixel region. In this particular exemplary embodiment, the pixel region corresponds approximately in size and shape to the aperture region 81, and most of the light generated by the pixel is generated in the pixel region.

A common electrode 95 is formed on the wall 80 and the organic light emitting layer 90. The common electrode 95 includes a reflective metal layer.

Holes from the pixel electrode 71 and electrons from the common electrode 95 combine in the organic light emitting layer 90 to form excitons. When the excitons relax or deactivate, light is emitted. The light generated in the organic light emitting layer 90 that travels toward the common electrode 95 is reflected from the common electrode 95 toward the pixel electrode 71. The light traveling toward the pixel electrode 71 is colored when it passes through the color filters 42, and then travels to the outside through the insulating substrate 11. This arrangement is referred to as a "bottom-emission" type of display.

In another possible exemplary embodiment of the present invention, the pixel electrode 71 may include a reflective metal, and the common electrode 95 may be transparent. In this case, light travels to the outside through the common electrode 95, which is referred to as a "top-emission" type of display. Accordingly, in this embodiment, the color filter 42 is formed on the common electrode 95.

In the first exemplary embodiment described above, the switching TFT Tsw is an amorphous silicon TFT in which the switching semiconductor layer 51 is made of amorphous silicon, and the driving TFT Tdr is a polysilicon TFT in which the driving semiconductor layer 21 is made of polysilicon.

Amorphous silicon TFTs have a relatively small leakage current, but their quality becomes unstable with use over time. Conversely, polysilicon TFTs have a relatively stable quality over time, but their leakage current is relatively large.

In the first exemplary embodiment above, by using the polysilicon TFT as the driving TFT Tdr, the leakage current of several nano amps (nA) thereof is sufficiently low as to prevent the light emitting diode LD from turning on when it is in an off state, so that the leakage current is not a problem. Conversely, if a polysilicon TFT were used as the switching TFT Tsw, the larger leakage current thereof could cause problems, such as crosstalk.

Thus, in the first exemplary embodiment above, the use of a polysilicon TFT for the driving TFT Tdr, even though it may have a relatively large leakage current, ensures that the quality of the display device will remain stable, and further, the use of an amorphous silicon TFT for the switching TFT Tsw prevents the occurrence of such problems as crosstalk.

In the meantime, the driving semiconductor layer 21 of the first exemplary embodiment is made of polysilicon and containing fluorine as the halogen material. The fluorine causes the properties of the driving TFT Tdr to be uniform over time, as described in more detail below.

In the case of the amorphous silicon TFT using amorphous silicon as a semiconductor layer, the thickness of the semiconductor layer in the channel region has little effect on the quality of the TFT. The reason for this is that the amorphous silicon thin film is a relatively low quality thin film having a lot of trap sites, and thus, the film properties are relatively insensitive to the thickness of the layer.

However, in the case of the polysilicon TFT using polysilicon as a semiconductor layer, the thickness of the semiconductor layer in the channel region has a relatively large effect on the quality of the TFT. The reason for this is that the trap sites of polysilicon are concentrated on a grain boundary, and thus, the film properties are sensitive to the layer thickness.

Polysilicon is obtained by crystallizing amorphous silicon. Amorphous silicon is formed by a chemical vapor deposition (CVD) using a silicon source gas, such as SiH₄, Si(C₂H₅O₄) or the like. In the chemical vapor deposition (CVD) process, the silicon source gas is deposited in the Si-H or Si-H2 state, and the amorphous silicon thin film thus contains a large amount of hydrogen.

The large amount of hydrogen is gasified during the crystallization and outgases into the atmosphere. Therefore, pure silicon containing no hydrogen forms a lattice structure of polysilicon, but impurities and defects are concentrated at the trap sites on the grain boundary. Accordingly, in polysilicon, the inside of the grain has relatively few trap sites, so that electron mobility is high. However, as discussed above, the properties of polysilicon layers are very sensitive to the thickness thereof.

As described above, the driving semiconductor layer 21 is relatively thin in the channel region because it is also partially removed in the process of removing the driving ohmic contact layer 22 of the channel region after forming the driving source electrode 33 and the driving drain electrode 34. If a uniform thickness of each driving semiconductor layer 21 were to be removed in each driving TFT Tdr, then the driving TFTs Tdr would all have a uniform quality. However, because of equipment limitations, it is difficult to remove a uniform thickness of the driving semiconductor layer 21 of each driving TFT Tdr.

However, fluorine contained in the driving semiconductor layer 21 causes the driving TFT Tdr to have a low sensitivity to the thickness of the driving semiconductor layer 21. In this instance, fluorine is incorporated into the driving semiconductor layer 21 as a fluorine source gas is added to the silicon source gas while the amorphous silicon thin film is being formed. For example, a silicon halide, such as SiF₄ may be used as the fluorine source gas.

Additionally, the fluorine does not vaporize away into the atmosphere during crystallization of the amorphous silicon layer because it is non-volatile, and does not concentrate on the grain boundary because it is immobile. Accordingly, the fluorine is uniformly distributed in the polysilicon and causes lattice distortions of the silicon that lower the degree of crystallization.

In this manner, the fluorine lowers the degree of crystallization and decreases the mobility of electrons in the semiconductor layer 21. However, the fluorine also causes the driving TFT Tdr to have relatively low sensitivity to the thickness of the driving semiconductor layer 21. Accordingly, each driving TFT Tdr has a uniform quality.

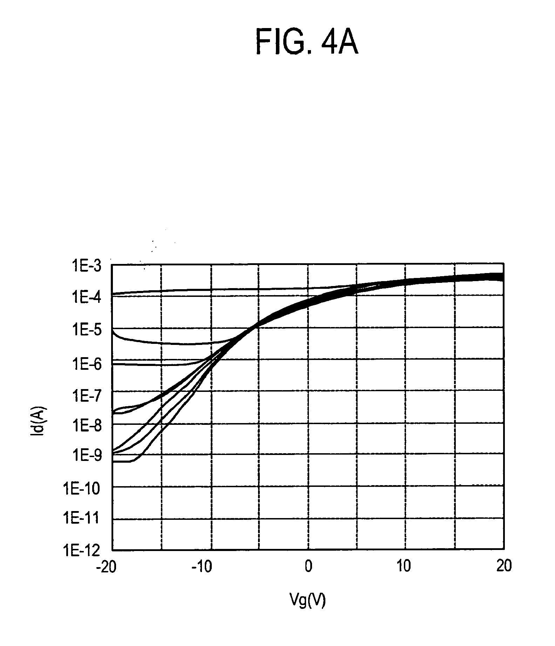

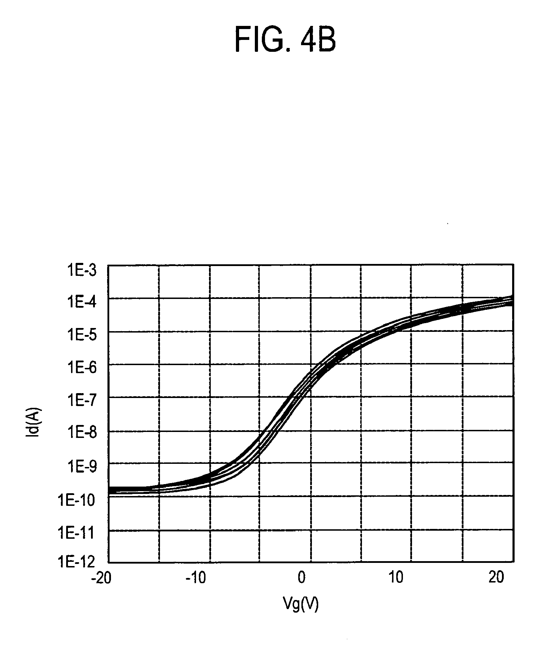

As described below with reference to FIGS. 4A and 4B, it is possible to verify experimentally that fluorine causes the TFTs to have a desirably uniform quality.

FIG. 4A is a graph illustrating the properties of eight TFTs manufactured at the same time under the condition that the semiconductor layer is made of polysilicon containing no fluorine. The polysilicon was formed by forming an amorphous silicon thin film by chemical vapor deposition method using SiH₄, and then applying solid phase crystallization to the amorphous silicon thin film, as described above.

FIG. 4B is a graph illustrating the properties of eight TFTs manufactured at the same time in which the respective TFT semiconductor layers are made of polysilicon containing fluorine. The polysilicon containing fluorine was formed by forming an amorphous silicon thin film containing fluorine by chemical vapor deposition method using SiH₄ and SiF₄, and then applying solid phase crystallization to the fluorine-containing amorphous silicon thin film, as described above. In this instance, the fluorine content in the semiconductor layer is about 2 at.%.

Comparing FIGS. 4A and 4B, it may be seen that the TFTs containing no fluorine have relatively non-uniform properties, i.e., on-current Id, particularly at increasingly negative gate voltages Vg, but that the TFTs containing fluorine have relatively uniform corresponding properties throughout the same gate voltage range.

The fluorine content in the semiconductor layer may range from 1 at.% through 3 at.%. If the fluorine content is less than 1 at.%, the quality of the TFTs is not as uniform. On the other hand, if the fluorine content is greater than 3 at.%, the degree of crystallization of the polysilicon is greatly decreased, thereby deteriorating both the initial properties and the stability of the TFTs. In particular, if the fluorine content is greater than 3 at.%, the large fluorine atoms cause high stresses in the semiconductor layer, so that the semiconductor layer may separate from an insulating layer on which the semiconductor layer is formed.

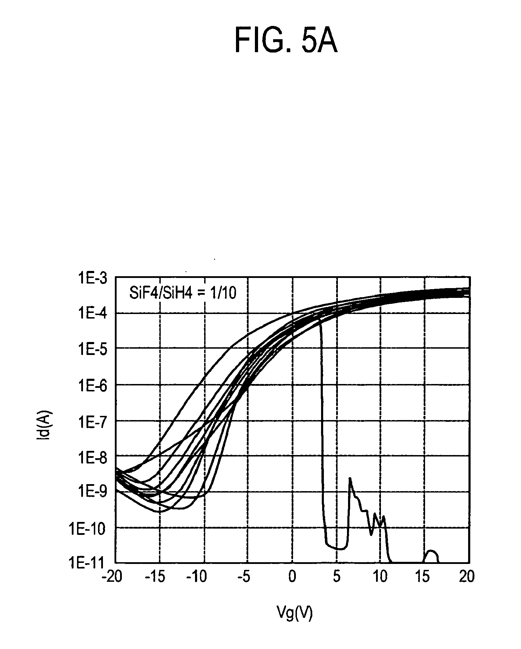

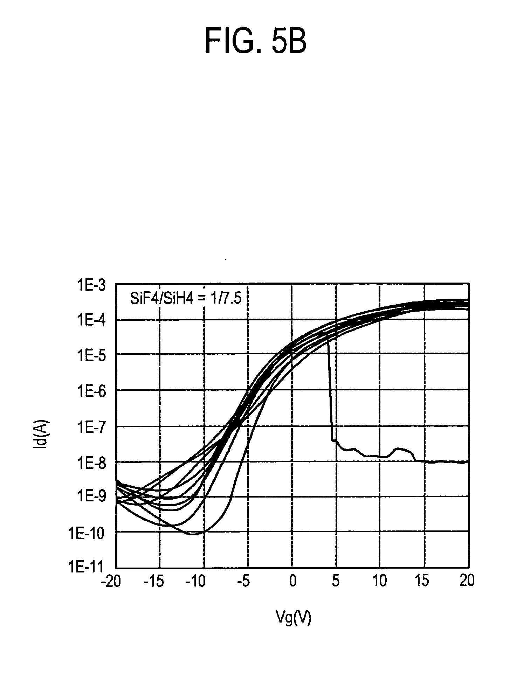

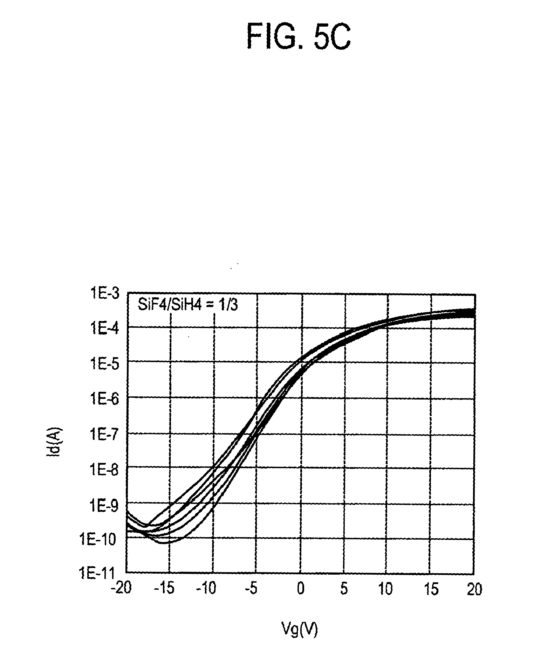

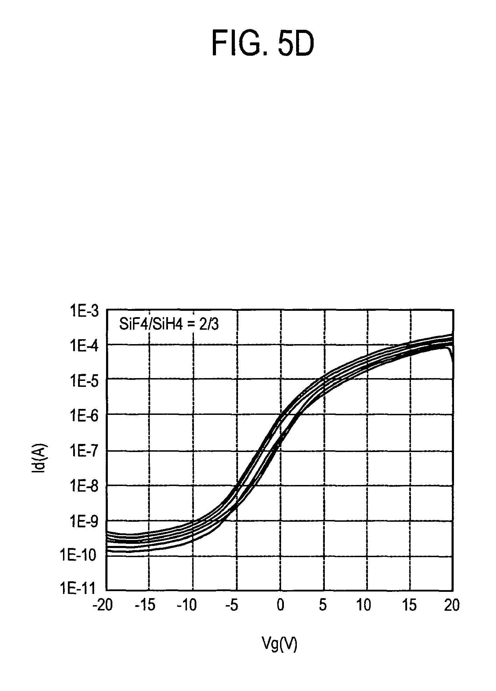

The fluorine content in the semiconductor layer varies depending on the flux ration, i.e., the ration of the respective fluxes of the silicon and fluorine source gases used during the formation of the amorphous silicon thin film. It is preferable, but not necessary, that the ratio of the flux of the fluorine source gas (SiF₄) to the flux of the silicon source gas (SiH₄) be between 1/3 to 2/3, as described in more detail below with reference to FIGS. 5A through 5D.

FIGS. 5A through 5D are graphs illustrating the dependency of the on-current Id properties of fourteen TFTs manufactured at the same time as a function of the respective flux ratios of SiF₄/SiH₄ source gases used during the formation of the respective amorphous semiconductor thin films thereof.

Referring to FIGS. 5A through 5D, it may be seen that the on-current Id properties of the TFTs are not uniform when the proportion of SiH₄ is relatively large, *i.e.*, when the ratio of SiF₄ to SiH₄ is 1/10 or even 1/7.5. However, the properties of the TFTs are much more uniform when the ratio of SiF₄/SiH₄ is in the range of from between 1/3 and 2/3. Where the ratio of SiF₄/SiH₄ is 1/3 or 2/3, the fluorine content in the semiconductor layer ranges from 1 at.% to 3 at.%. Although the SiF₄ flux is relatively large, the fluorine content of the flow is relatively small. This is because the fluorine source gas is not well decomposed as compared with the silicon source gas.

Although not illustrated in the graphs, if the ratio of SiF₄/SiH₄ is greater than 2/3, the fluorine content becomes proportionally larger, and as described above, the degree of crystallization of the polysilicon is greatly decreased, thereby deteriorating the initial properties and stability of the TFTs.

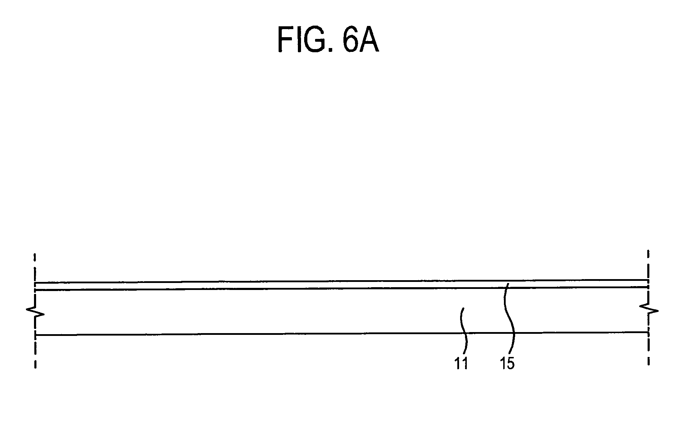

FIGS. 6A through 6L are partial cross-sectional views of the first exemplary display device, showing sequential processes involved in an exemplary embodiment of a method for manufacturing the device in accordance with the present invention.

As illustrated in FIG. 6A, the buffer layer 15 is formed on the insulating substrate 11. The buffer layer 15 may be formed by a chemical vapor deposition method using an oxygen source gas and a silicon source gas.

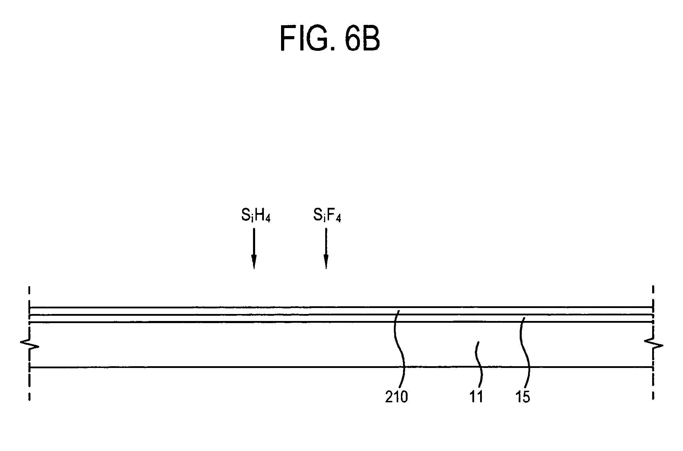

As illustrated in FIG. 6B, an amorphous silicon layer 210 is then formed on the buffer layer 15 by a chemical vapor deposition method using the silicon source gas (SiH₄) and the fluorine source gas (SiF₄). At this time, the SiF₄ to SiH₄ flux ratio ranges from 1/3 to 2/3, and fluorine is thereby uniformly distributed in the amorphous silicon layer 210.

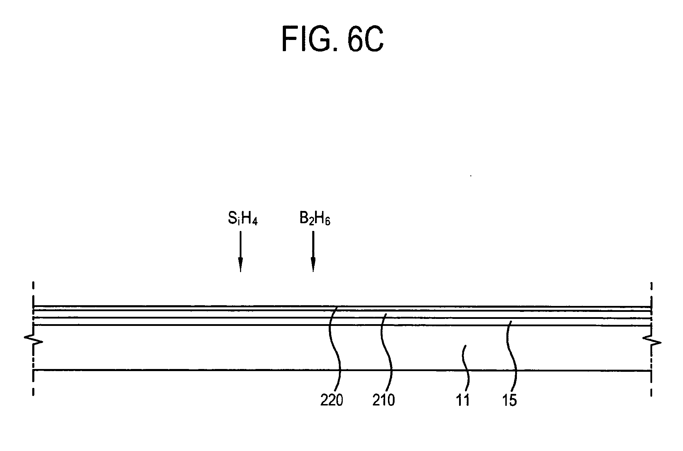

As illustrated in FIG. 6C, an amorphous ohmic contact layer 220 is then formed on the structure by a chemical vapor deposition method using the silicon source gas (SiH₄) and an n-type impurity source gas (B₂H₆). Alternatively, the silicon source gases respectively used to form the amorphous silicon layer 210 and the amorphous ohmic contact layer 220 may be different from each other.

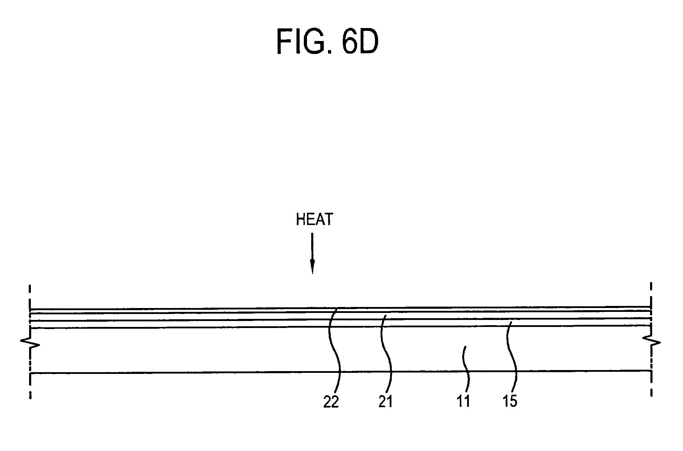

As illustrated in FIG. 6D, the driving semiconductor layer 21 and the driving ohmic contact layer 22 are formed by crystallizing the amorphous silicon layer 210 and the amorphous ohmic contact layer 220 into polysilicon. Through the crystallization process, both the patterned amorphous silicon layer 210 and the patterned amorphous ohmic contact layer 220 are changed into polysilicon.

Here, solid phase crystallization (SPC), laser crystallization (LC), rapid thermal annealing (RTA), or the like, may be employed to effect the crystallization. Solid phase crystallization (SPC) is a method of annealing the amorphous silicon for a relatively long time at a relatively low temperature, thereby obtaining crystalline silicon with a relatively large grain size. Laser crystallization is a method, such as excimer laser annealing (ELA), sequential lateral solidification (SLS), that uses a laser to obtain the crystalline silicon. Rapid thermal annealing (RTA) is a method that deposits amorphous silicon at a low temperature and then anneals the surface of the amorphous silicon rapidly with light.

As discussed above, the fluorine incorporated into the amorphous silicon layer 210 is not gasified during the crystallization, so is not removed therefrom. Therefore, the fluorine is uniformly distributed throughout the grain and the grain boundary of the driving semiconductor layer 21 during the latter's formation.

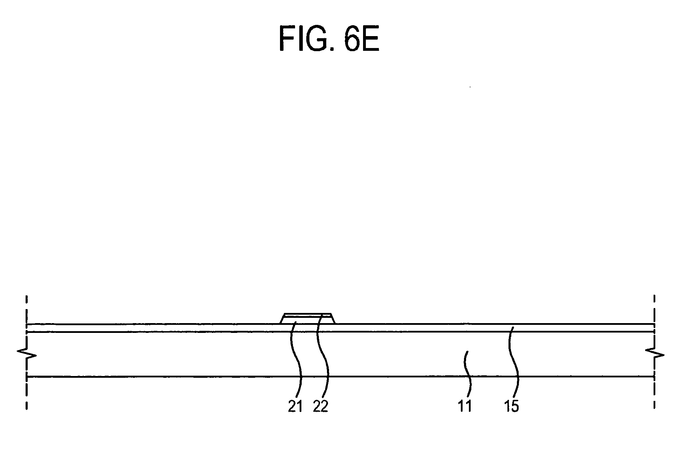

As illustrated in FIG. 6E, the driving semiconductor layer 21 and the driving ohmic contact layer 22 are then patterned by photolithography. Alternatively, the order of the crystallization and the patterning may be reversed.

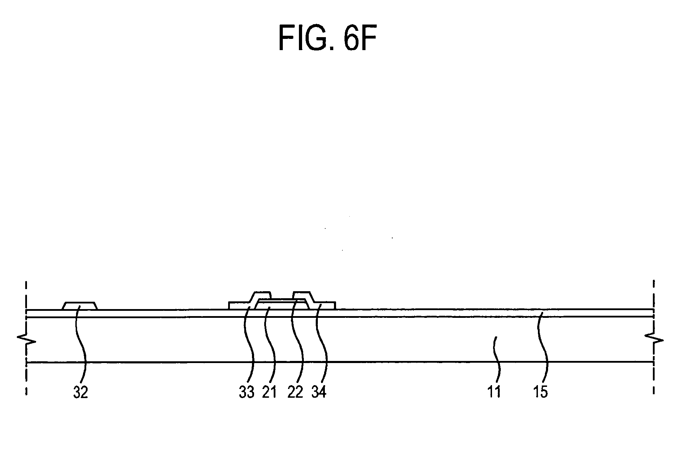

As illustrated in FIG. 6F, the switching gate electrode 32, the driving source electrode 33 and the driving drain electrode 34 are formed by depositing and patterning a metal layer. Here, the driving source electrode 33 and the driving drain electrode 34 are spaced apart from each other, with the channel region disposed therebetween.

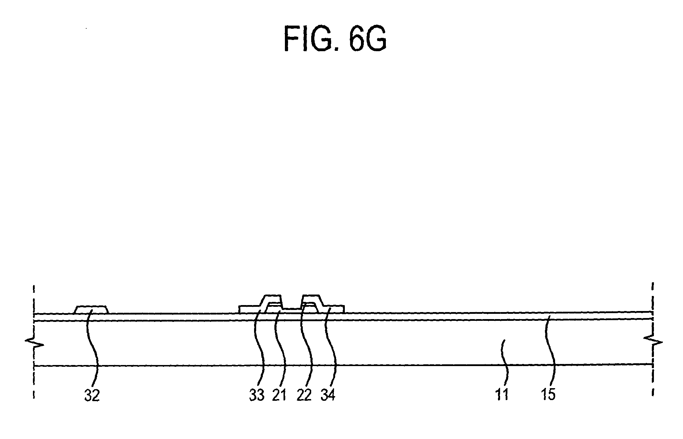

As illustrated in FIG. 6G, the driving ohmic contact layer 22 exposed in the channel region is then removed. During this stage, the driving semiconductor layer 21 is also partially removed in the channel region, so that the thickness of the driving semiconductor layer 21 decreases in the channel region, thereby completing the fabrication of the driving TFT Tdr.

As discussed above, in the channel region, each driving TFT Tdr may have a driving semiconductor layer 21 with a different thickness than the others. However, as explained above, the quality of the driving TFTs Tdr is not sensitive to the thickness of their respective driving semiconductor layers 21 because of the presence of the fluorine.

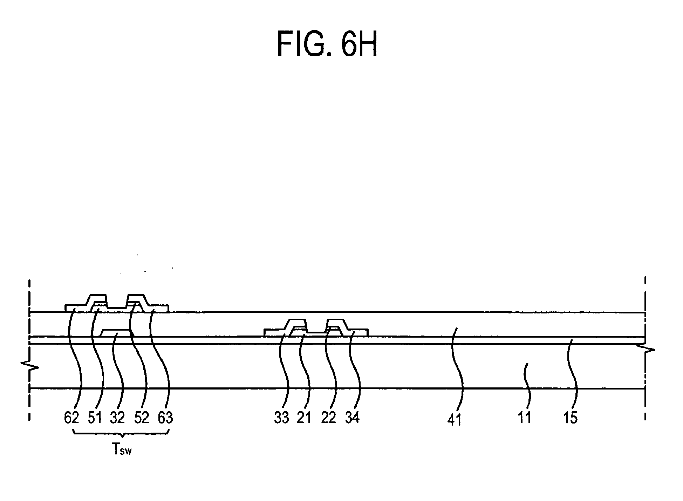

As illustrated in FIG. 6H, the first insulating layer 41 is formed over the structure, and then the switching semiconductor layer 51, the switching ohmic contact layer 52, the switching source electrode 62, the switching drain electrode 63 and the driving gate electrode 64 are formed on the first insulating layer 41, thereby completing the manufacture of the switching TFT Tsw.

Here, the switching semiconductor layer 51 is formed using only the silicon source gas and without the crystallization. Accordingly, the switching semiconductor layer 51 is made of amorphous silicon containing no fluorine.

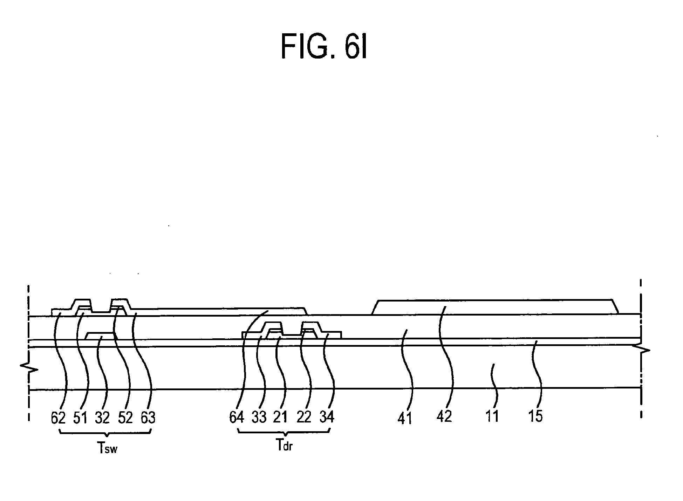

As illustrated in FIG. 6I, the color filter 42 is formed by coating, exposing and developing a color filter photosensitive layer on the structure.

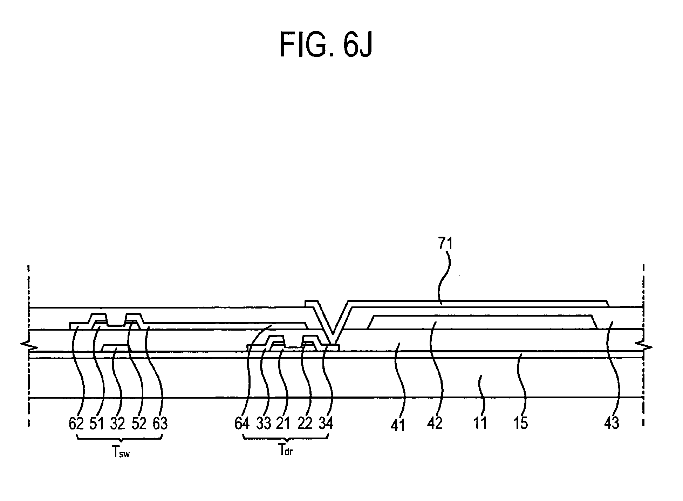

As illustrated in FIG. 6J, the second insulating layer 43 is then formed on the structure, and the transparent conducting layer, such as ITO, IZO or the like, is then deposited and etched by photolithography to form the pixel electrode 71.

Before the transparent conducting layer is deposited, the insulating layers 41 and 42 are patterned to form the contact hole 44.

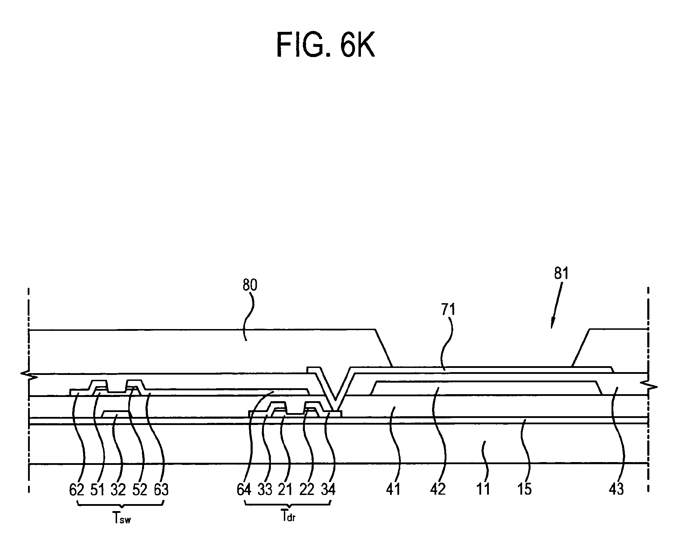

As illustrated in FIG. 6K, after the pixel electrode 71 is formed, the wall 80 is formed by depositing, exposing and developing a wall material layer over the entire surface of the pixel electrode 71. The wall material layer includes a photosensitive material and may be deposited by slit coating, spin coating or the like. The wall 80 may be formed to include the aperture region 81 through which the pixel electrode 71 is exposed.

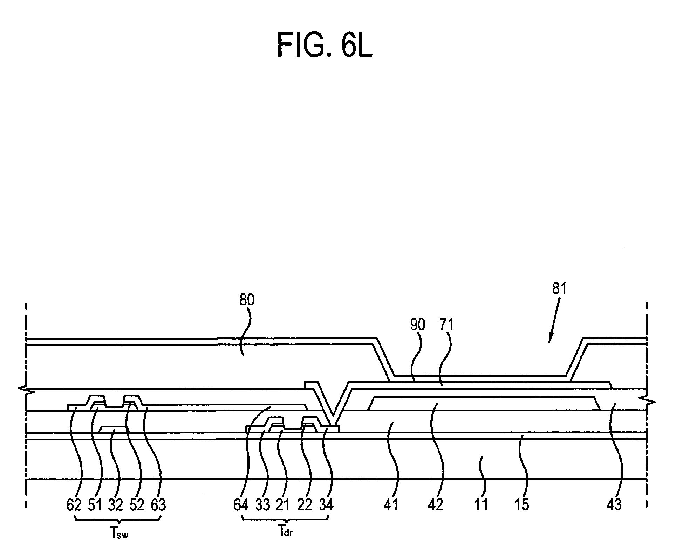

As illustrated in FIG. 6L, the organic light emitting layer 90 is then formed by an evaporation process. During the evaporation process, the insulating substrate 11 is disposed such that the pixel electrode 71 faces downward, and an organic source situated below the insulating substrate 11 then heated to supply the organic vapor. A mask may be interposed between the organic source and the insulating substrate 11 during the vapor deposition.

Then, the common electrode 95 is formed on the structure, thereby completing the manufacture of the display device 1 of FIGS. 2 and 3.

In the first exemplary embodiment, SiH₄ is used as the exemplary silicon source gas, but is not limited thereto. Alternatively, Si(C₂H₅O₄) or other Si-containing gases may be used as the silicon source gas. Moreover, fluorine is used as the exemplary halogen material, but is not limited thereto. Alternatively, chlorine may be used as the halogen material. For example, SiCl₄ or SiH₂Cl₂ may be employed as chlorine source gases.

In the first exemplary embodiment, the driving TFT Tdr illustrated has a top-gate structure in which the driving gate electrode 64 is placed above the driving semiconductor layer 21. Alternatively, the driving TFT Tdr may have a bottom-gate structure in which the driving gate electrode 64 is placed below the driving semiconductor layer 21.

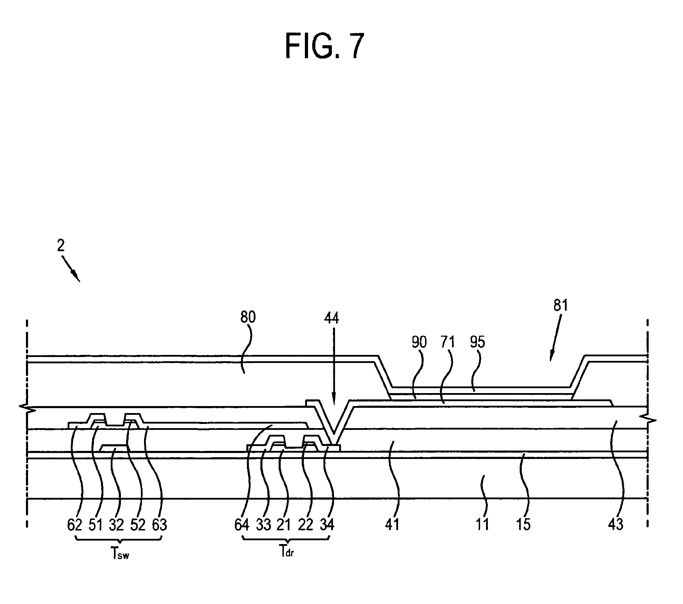

A second exemplary embodiment of a display device 2 in accordance with the present invention is described below with reference to FIG. 7.

Most of the organic light emitting layer 90 is formed within the pixel region, as illustrated in FIG. 7. If the organic light emitting layer 90 includes a polymer material, the organic light emitting layer 90 may be formed within the pixel region by an inkjet printing method.

The organic light emitting layer 90 may include polyfluorene derivatives, polypara-phenylene vinylene derivatives, polyphenylene derivatives, polyvinylcarbazole derivatives, polythiophene derivatives, or like polymer materials, doped with a perillene group pigment, a rothermine group pigment, rubrene, perillene, 9,10-diphenylanthracene, tetraphenylbutadiene, Nile red, cumarine 6, quinacridone, and the like.

Although not shown in the figures, a hole injection layer may be interposed between the pixel electrode 71 and the organic light emitting layer 90. The hole injection layer may include a hole injection material, such as poly(3,4-ethylenedioxy thiophene)(PEDOT) and polystyrene sulfonic acid (PSS).

The organic light emitting layer 90 of FIG. 7 emits different colors of light according to the particular color composition thereof, and accordingly, there is no need for the use of a color filter in association therewith.

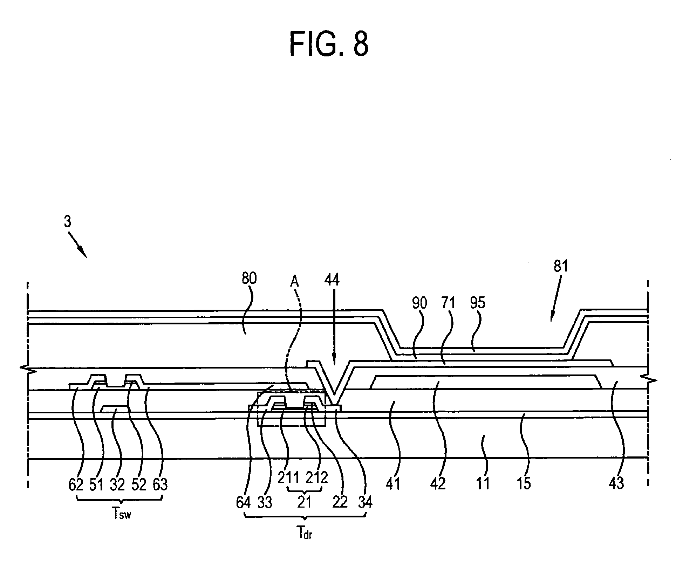

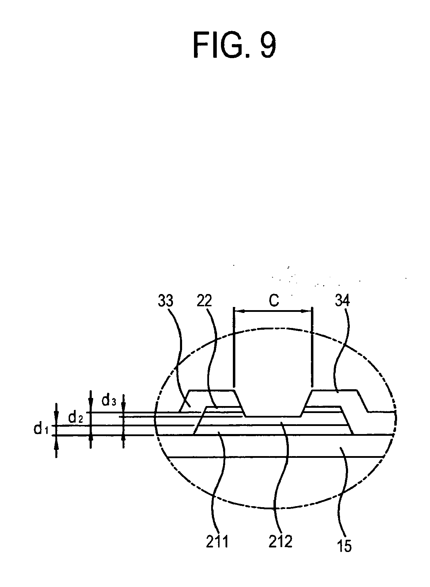

A third exemplary embodiment of a display device 3 in accordance with the present invention is described below with reference to FIGS. 8 and 9.

As illustrated in FIGS. 8 and 9, in this embodiment, the driving semiconductor layer 21 includes a first upper layer 211 and a second lower layer 212. The first layer 211 includes polysilicon containing fluorine as the halogen material. In the first layer 211, the fluorine content ranges from 1 at.% through 3 at.%. Further, the fluorine is relatively uniformly distributed in the first driving semiconductor layer 211.

Alternatively, the first layer 211 may contain another halogen material, such as bromine or chlorine. As discussed above, the halogen material contained in the first layer 211 imbues the driving TFT Tdr with uniform properties.

The second layer 212 includes polysilicon containing no halogen material, such as fluorine or the like. Alternatively, the second layer 212 may have a halogen content that is lower than the first layer 211.

The thickness d1 of the first layer 211 is 20% to 60% of the thickness d2 of the second layer 212. The total thickness of the driving semiconductor layer 21 may range from 1000 to 2000 Å.

In the channel region C, the ohmic contact layer 23 is removed to expose the driving semiconductor layer 21. The thickness of the driving semiconductor layer 21 thereby decreases in the channel region C. Thus, in this embodiment, while the thickness of the second layer 212 decreases, the thickness of the first layer 211 remains the same.

In the channel region C, the thickness d3 of the second layer 212 is less than the thickness d1 of the first layer 211, and thus, the channel region C is occupied mostly by the first layer 211. As described above, the thickness of the second layer 212 decreases in the channel region C because it is partially removed while the ohmic contact layer 22 is being removed in the channel region after forming the driving source electrode 33 and the driving drain electrode 34. Thus, most of the second layer 212 is removed in the channel region C, so that the channel region C is occupied mostly by the first layer 211. As described in the first exemplary embodiment above, fluorine contained in the first layer 211 lowers the sensitivity of the driving TFT Tdr to the thickness of the driving semiconductor layer 21 thereof.

The relative positional and thickness relationships between the first and second layers 211 and 212 is described in more detail below.

Where the first layer 211 containing fluorine is placed on the second layer, the channel region is mostly occupied by the second layer 212 that contains no fluorine, so that the driving TFT Tdr is sensitive to the thickness of the second layer 212.

In the meantime, the fluorine source gas has a relatively strong combining force, so that its deposition speed is low. Specifically, if the silicon halide, such as SiF₄, is used as the fluorine source gas, the deposition speed of the fluorine source gas is about a half to a third of the deposition speed of the silicon source gas, so that processing time increases.

In addition to the increased processing time, if the thickness of the first layer 211 is greater than 60% of the thickness of the second layer 212, the properties of the driving TFT Tdr, such as on-current Id, mobility and the like, are deteriorated. On the other hand, if the thickness of the first layer 211 is less than 20% of the thickness of the second layer 212, the channel region is occupied mostly by the second layer 212 containing no fluorine, so that the driving TFT Tdr is sensitive to the thickness of the second layer 212.

Accordingly, it is preferable but not necessary that the thickness of the first layer 211 be about 20% to 60% of the thickness of the second layer 212.

Thus, in accordance with the third exemplary embodiment, not only is the driving TFT Tdr insensitive to the thickness of the driving semiconductor layer 211, but the manufacturing time for the driving semiconductor layer 211 is also reduced.

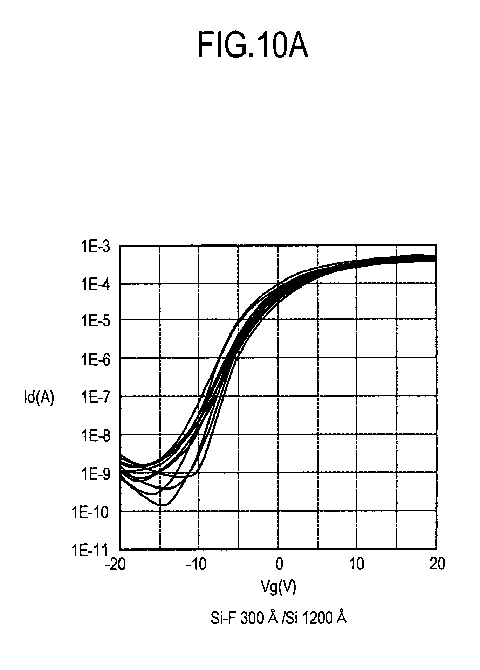

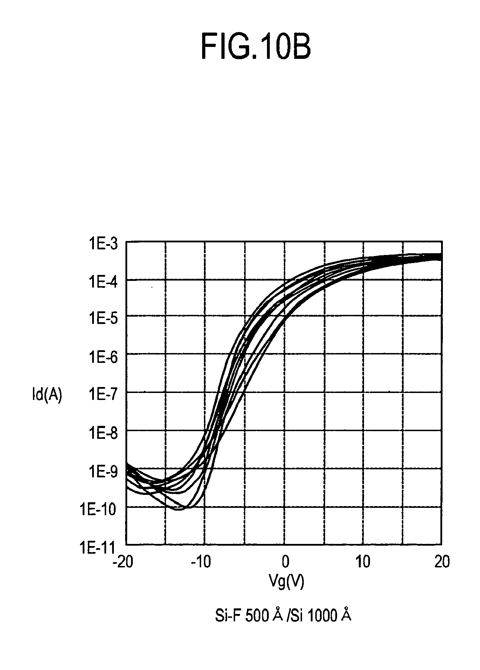

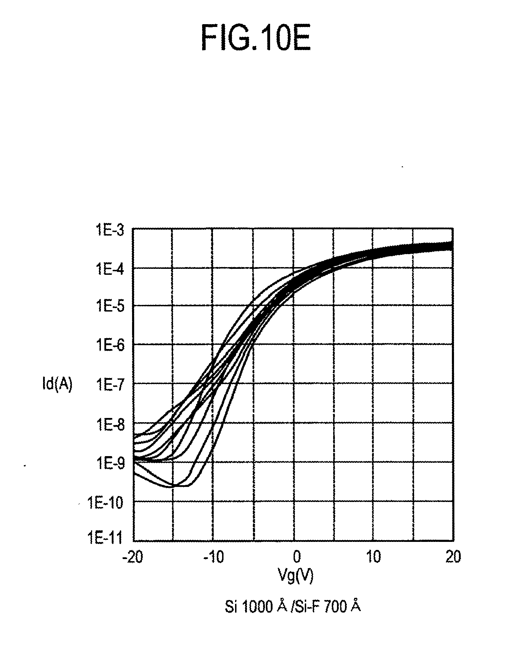

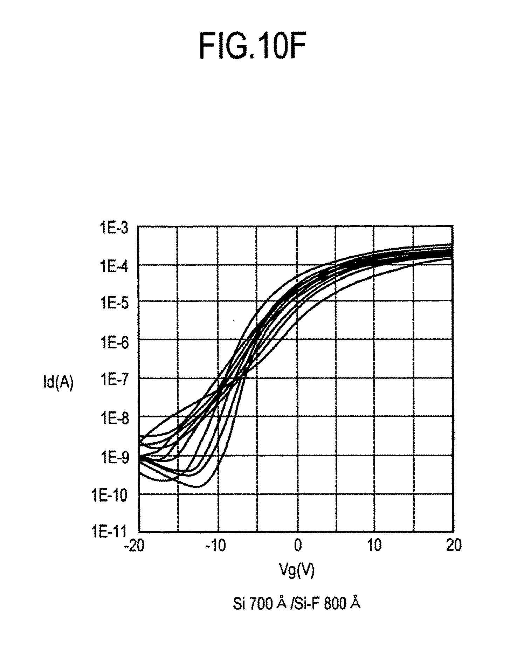

The foregoing position and thickness relationships have been experimentally verified, as described below with reference to FIGs. 10A through 10F.

FIGs. 10A through 10F are graphs illustrating the properties of six groups of TFTs, each of which was manufactured at the same time, each containing eight TFTs, each TFT including a two-layered semiconductor layer having a total thickness of about 1500 Å. The layer containing fluorine was formed by chemical vapor deposition method using SiH₄ and SiF₄, and the layer containing no fluorine was formed by chemical vapor deposition using only SiH₄. These two layers were then crystallized by solid phase crystallization and patterned at the same time. Additionally, the layer containing fluorine had a fluorine content of about 2 at.%.

In the experiments shown graphically in FIGS. 10A through 10C, polysilicon (Si-F) containing fluorine formed the lower of the two-layered semiconductor layer, and polysilicon (Si) containing no fluorine formed the upper layer. In other words, this set of graphs relates to SiF (lower layer)/Si (upper layer) structures.

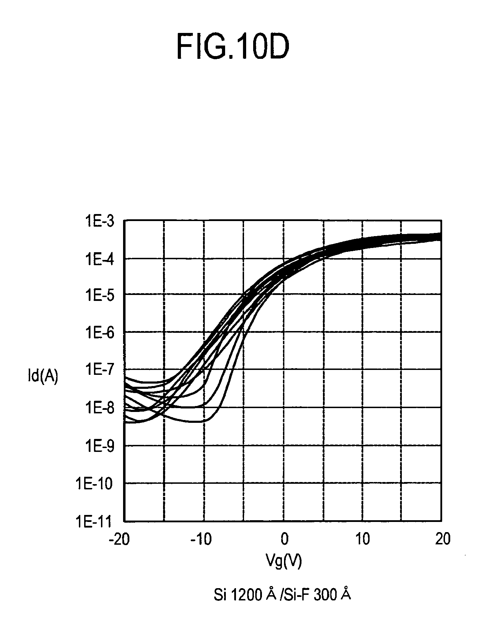

In the experiments shown graphically in FIGS. 10D through 10F, polysilicon (Si-F) containing fluorine formed the upper layer, and polysilicon (Si) containing no fluorine formed the lower layer of the two-layered semiconductor layer. In other words, this latter set of graphs relates to Si (lower layer)/SiF(upper layer) structures.

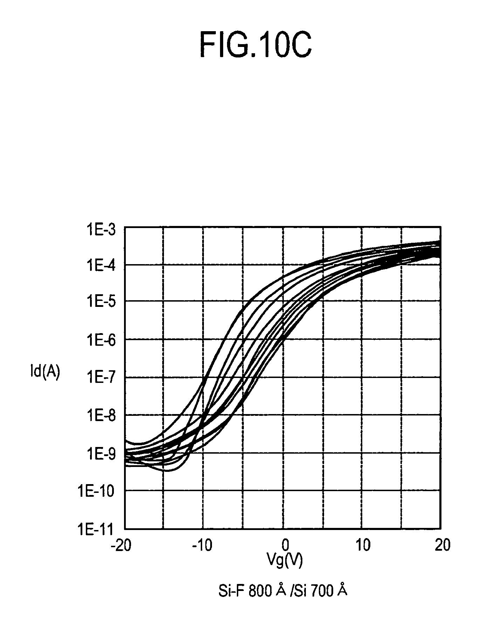

Referring to the graphs, it may be seen that the on-current Id properties of the TFTs having the SiF (lower layer)/Si (upper layer) structure are more uniform than those of the TFTs having the Si (lower layer)/SiF (upper layer) structure. Further, where the SiF layer is thicker than the Si layer (see, *e.g.*, FIG. 10C), the on-current is lowered.

An exemplary method for manufacturing the driving semiconductor layer 21 of the third exemplary embodiment is as follows.

Three layers comprising a first amorphous silicon layer containing fluorine, a second amorphous silicon layer containing no fluorine, and an amorphous ohmic contact layer are formed on the buffer layer 15. The three layers are then crystallized and patterned.

The following processes are respectively the same as those of the first exemplary embodiment described above, and further detailed descriptions of these is therefore omitted for brevity.

The first amorphous silicon layer is manufactured by the method described in connection with the first exemplary embodiment above, and the second amorphous silicon layer is manufactured by a known method using the silicon source gas.

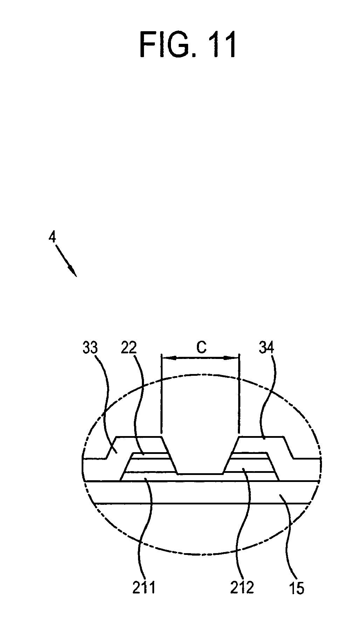

Referring to FIG. 11, a fourth exemplary embodiment of a display device 4 in accordance with the present invention is described below, wherein FIG. 11 is enlarged view of an alternative embodiment of the portion "A" of the exemplary display of FIG. 8 outlined by phantom lines.

In the channel region, the second layer 212 is completely removed, so that the first layer 211 is exposed. Thus, in the fourth exemplary embodiment, the channel region includes only the first layer 211, so that the driving TFT Tdr has a low sensitivity to the thickness of the driving semiconductor layer 21.

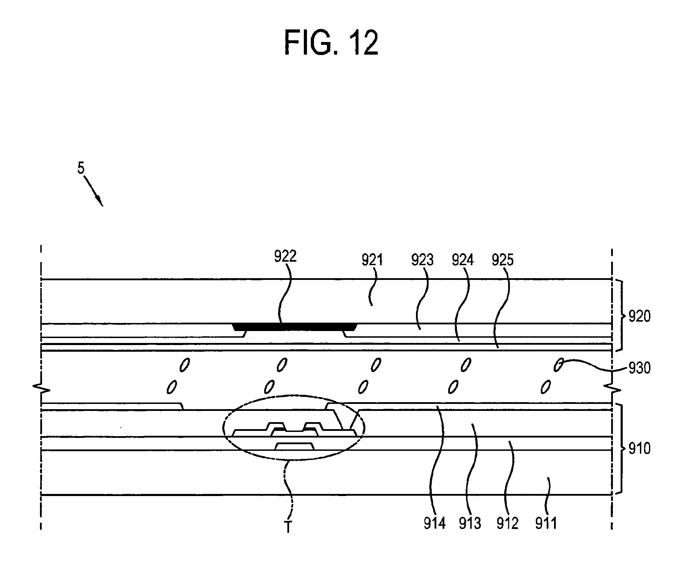

A fifth exemplary embodiment of a display device 5 in accordance with the present invention is described below with reference to FIG. 12.

The fifth exemplary display device 5 comprises a liquid crystal display (LCD) device that includes a first substrate 910 formed with a TFT T, a second substrate 920 disposed opposite to the first substrate, and a liquid crystal layer 930 interposed between the first and second substrates 910 and 920. The semiconductor layer of the TFT includes fluorine and polysilicon.

The first substrate 910 includes an insulating substrate 911, insulating layers 912 and 913, and a pixel electrode 914.

In the second substrate 920, a black matrix 922 is formed on a second insulating substrate 921. The black matrix 922 may include an organic material containing a black pigment, and is configured to correspond in size and shape to the TFT T and a wiring line (not shown) of the first substrate 910.

A color filter 923 is provided in each of the interstices of the black matrix 922. The color filters 923 are made of an organic material, and include a plurality of sub-layers having different colors. Further, an overcoat layer 924 and a common electrode 925 that is made of a transparent conducting material are formed on the black matrix 922 and the color filter layer 923.

The molecular arrangement of the liquid crystal layer 930 interposed between the first and second substrates 910 and 920 is varied in accordance with an electric field applied between the respective pixel electrodes 914 and the common electrode 925.

In accordance with the exemplary embodiments described above, the present invention provides display devices having improved stability of display quality and methods for manufacturing the same.

Although a number of exemplary embodiments of the present invention have been illustrated and described herein by way of example, it will be appreciated by those skilled in the art that changes may be made in these embodiments without departing from the principles and spirit of the invention, the scope of which is defined by the appended claims and their functional equivalents.

## Claims

1. A display device, comprising:
an insulating substrate;
a switching TFT formed on the insulating substrate, the switching TFT receiving a data voltage and comprising a first semiconductor layer;
a driving TFT formed on the insulating substrate, the driving TFT having a control terminal connected to an output terminal of the switching TFT and comprising a second semiconductor layer including polysilicon and a halogen material;
an insulating layer formed on the switching TFT and the driving TFT;
a first electrode formed on the insulating layer and electrically connected to an output terminal of the driving TFT;
an organic light emitting layer formed on the first electrode; and,
a second electrode formed on the organic light emitting layer.

2. The display device of claim 1, wherein the first semiconductor layer includes amorphous silicon.

3. The display device of claim 1, wherein the halogen material includes fluorine.

4. The display device of claim 1, wherein the second semiconductor layer in a channel region of at least one of the TFTs has a thickness that is less than the thickness of the second semiconductor layer in a region surrounding the channel region.

5. The display device of claim 1, wherein the second semiconductor layer has a halogen content ranging from 1 at.% to 3 at.%.

6. The display device of claim 1, wherein the halogen material is uniformly distributed in the second semiconductor layer.

7. The display device of claim 1, wherein the driving TFT further comprises a gate electrode, the gate electrode being disposed between the second semiconductor layer and the second electrode and corresponding in size and shape to the channel region.

8. The display device of claim 7, further comprising a buffer layer that includes silicon oxide interposed between the insulating substrate and the second semiconductor layer.

9. The display device of claim 1, wherein the second semiconductor layer comprises a first layer including the halogen material at a first content, and a second layer formed on the first layer and including the halogen material at a second content that is less than the first content.

10. The display device of claim 9, wherein the first layer has a uniform thickness.

11. The display device of claim 9, wherein the halogen content of the second layer is substantially zero.

12. A method of manufacturing a display device, the method comprising:
forming an amorphous silicon layer on an insulating substrate while supplying a first silicon source gas and a halogen source gas thereto;
forming an amorphous ohmic contact layer on the amorphous silicon layer while supplying a second silicon source gas and an impurity source gas thereto;
forming a semiconductor layer and an ohmic contact layer by crystallizing and patterning the amorphous silicon layer and the amorphous ohmic contact layer;
forming a source electrode and a drain electrode on the ohmic contact layer, the source and drain electrodes being spaced apart from each other and having a channel region disposed therebetween;
exposing the semiconductor layer by removing the portion of the ohmic contact layer that is not covered by the source electrode and the drain electrode;
forming an insulating layer on the source electrode, the drain electrode and the exposed semiconductor layer; and,
forming a gate electrode corresponding in size and shape to the exposed semiconductor layer on the insulating layer.

13. The method of claim 12, wherein a flux ratio of the halogen source gas to the first silicon source gas ranges from 1/3 to 2/3.

14. The method of claim 13, wherein the halogen source gas includes silicon halide.

15. The method of claim 14, wherein the halogen source gas includes SiF₄, and the silicon source gas includes SiH₄.

16. The method of claim 12, wherein the crystallizing is performed by a solid phase crystallization method.

17. The method of claim 12, further comprising forming a pixel electrode connected to the drain electrode.

18. The method of claim 17, further comprising forming an organic light emitting layer on the pixel electrode.

19. A method of manufacturing a display device, the method comprising:
forming a switching TFT and a driving TFT on an insulating substrate, the driving TFT comprising a control terminal electrically connected to an output terminal of the switching TFT;
forming a first electrode that is electrically connected to the driving TFT;
forming an organic light emitting layer on the first electrode; and,
forming a second electrode on the organic light emitting layer,
wherein the forming of the driving TFT comprises:
forming an amorphous silicon layer on the insulating substrate while supplying a first silicon source gas and a halogen source gas thereto;
forming an amorphous ohmic contact layer on the amorphous silicon layer while supplying a second silicon source gas and an impurity source gas thereto;
forming a semiconductor layer and an ohmic contact layer by crystallizing and patterning the amorphous silicon layer and the amorphous ohmic contact layer;
forming a source electrode and a drain electrode on the ohmic contact layer, the source and drain electrodes being spaced apart from each other and having a channel region disposed therebetween;
exposing the semiconductor layer by removing the portion of the ohmic contact layer that is not covered by the source electrode and the drain electrode;
forming an insulating layer on the source electrode, the drain electrode and the exposed semiconductor layer; and,
forming a gate electrode corresponding to the exposed semiconductor layer on the insulating layer.

20. The method of claim 19, wherein a flux ratio of the halogen source gas to the first silicon source gas ranges from 1/3 to 2/3.

21. A method for manufacturing a display device, the method comprising:
forming a first amorphous silicon layer on an insulating substrate while supplying a first silicon source gas and a halogen source gas thereto;
forming a second amorphous silicon layer on the first amorphous silicon layer while supplying a second silicon source gas thereto;
forming an amorphous ohmic contact layer on the second amorphous silicon layer while supplying a third silicon source gas and an impurity source gas thereto;
forming a semiconductor layer and an ohmic contact layer by crystallizing and patterning the first amorphous silicon layer, the second amorphous silicon layer and the amorphous ohmic contact layer;
forming a source electrode and a drain electrode on the ohmic contact layer, the source and drain electrodes being spaced apart from each other and having a channel region disposed therebetween; and,
removing the portion of the ohmic contact layer that is not covered by the source electrode and the drain electrode.
